# FASCICULE DE BREVET EUROPEEN

(11) **EP 2 158 604 B1**
(45) Date de publication et mention de la délivrance du brevet: **19.10.2016**
(21) Numéro de dépôt: 08806014.0
(22) Date de dépôt: 18.06.2008
(51) Int. Cl.: G06K 19/077, H01L 21/98, H01L 25/065, D02G 3/44, H01L 23/00, H01L 23/538, H01L 21/683, H01L 25/00, H01Q 1/22

(54) **ASSEMBLAGE DE PUCES RADIOFREQUENCE**
ZUSAMMENBAU VON HOCHFREQUENZCHIPS
ASSEMBLAGE OF RADIOFREQUENCY CHIPS

(30) Priorité: 21.06.2007 FR 0704445
(43) Date de publication de la demande: 03.03.2010
(73) Titulaire: Commissariat à l'Énergie Atomique et aux Énergies Alternatives, 75015 Paris (FR)
(72) Inventeur: VICARD, Dominique, F-38330 Saint Nazaire Les Eymes (FR); BRUN, Jean, F-38800 Champagnier (FR); LEPINE, Benoît, F-38000 Grenoble (FR)
(74) Mandataire: Thibon, Laurent
(86) Numéro de dépôt international: PCT/FR2008/051079
(87) Numéro de publication internationale: WO 2009/004243

(56) Documents cités:
- EP-A- 1 630 728
- DE-A1- 19 908 172
- US-A1- 2007 098 942

## Description

### Domaine de l'invention

La présente invention concerne de façon générale les circuits électroniques et, plus particulièrement, la réalisation de dispositifs microélectroniques équipés de moyens d'émission-réception radiofréquence.

### Etat de la technique

Les dispositifs microélectroniques d'émission-réception radiofréquence sont de plus en plus utilisés à des fins d'identification à distance d'objets auxquels ces dispositifs sont associés. On parle alors souvent d'étiquettes électroniques (RFID tag). Les fonctionnalités de telles étiquettes électroniques peuvent se borner à la transmission d'un identifiant ou inclure des fonctions plus complexes (transmission à distance de résultats de mesures effectuées par des capteurs intégrés à la puce, traitement de données reçues depuis un élément distant, etc.).

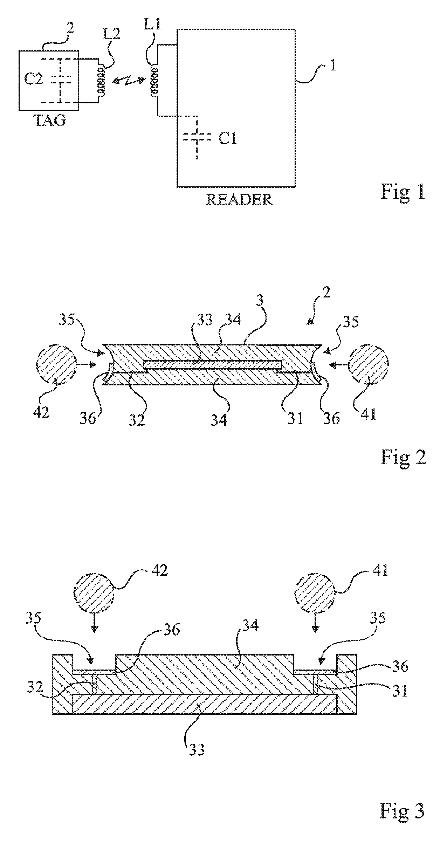

La figure 1 est un schéma-bloc simplifié d'un système de communication radiofréquence entre un terminal 1 de lecture (READER) ou de lecture-écriture et un dispositif électronique 2 (TAG) de type étiquette électronique. Le terminal 1 et l'étiquette 2 comportent des antennes, schématisées par des éléments inductifs L1 et L2. Selon la bande de fréquence utilisée pour la transmission, les antennes L1 et L2 sont en boucle ou en dipôle. Dans l'exemple représenté en figure 1, les éléments inductifs L1 et L2 sont respectivement en série et en parallèle avec des éléments capacitifs C1 et C2 (représentés en pointillés) avec lesquels ils forment des circuits oscillants, généralement accordés sur une fréquence centrale d'une bande de fréquences de fonctionnement.

Typiquement, pour des bandes de fréquence de quelques centaines de kilohertz à quelques dizaines de Mégahertz, les antennes L1 et L2 ont des formes de boucles et pour des fréquences de l'ordre de plusieurs centaines de Mégahertz à quelques Gigahertz, les antennes sont de type dipôle.

Le plus souvent, l'étiquette électronique 2 tire l'alimentation nécessaire au fonctionnement des circuits électroniques qu'elle comporte du champ radiofréquence rayonné par le terminal 1.

De nombreuses structures d'étiquettes électroniques et plus généralement de puces d'émission-réception radiofréquence, et de terminaux de lecture ou de lecture-écriture, sont disponibles.

La réalisation de l'antenne L2 côté étiquette électronique fait appel à des techniques dérivées de l'industrie microélectronique dans la fabrication des circuits intégrés ou imprimés (gravure ou impression de pistes conductrices). Cela constitue un élément non négligeable du coût de l'étiquette électronique.

Il serait souhaitable de disposer d'un dispositif d'émission-réception radiofréquence dont la réalisation de l'antenne soit moins onéreuse.

Il serait par ailleurs souhaitable de disposer d'un procédé de fabrication simplifié d'un dispositif d'émission-réception radiofréquence équipé de son antenne.

Dans certaines applications, on souhaite associer plusieurs étiquettes électroniques à un même objet. Celles-ci doivent être alors attachées individuellement à l'objet concerné (par exemple, un tuyau de grande longueur).

On connaît du document WO-A-2008/025889, une technique de réalisation de puces microélectroniques connectées les unes aux autres par un élément filaire de connexion électrique entre la puce et l'extérieur, plusieurs fils pouvant être prévus pour constituer alors à la fois des antennes et l'alimentation d'un composant RFID.

Le document EP 1 630 728 décrit un procédé de fabrication d'étiquettes électroniques connectées les unes aux autres par des éléments filaires conducteurs.

Le document DE 19908172 décrit un procédé dans lequel des puces sont raccordées deux à deux par des tronçons conducteurs discontinus.

Le document US 2007/098942 décrit un procédé de fabrication d'étiquettes électroniques dans lequel des puces voisines sont reliées par des éléments filaires conducteurs.

Il serait souhaitable de tirer profit de cette technique pour faciliter la réalisation d'antennes de dispositifs d'émission-réception radiofréquence sans qu'elles soient reliées entre elles par un fil d'alimentation.

Il serait par ailleurs souhaitable de disposer d'une solution simple pour associer plusieurs puces d'émission-réception radiofréquence, que ce soit avant leur montage sur l'objet auquel elles sont destinées ou en utilisation.

Pour atteindre tout ou partie de ces objets ainsi que d'autres, il est prévu un procédé de fabrication de dispositifs d'émission-réception radiofréquence, une chaîne de dispositif d'émission-réception radiofréquence et une canalisation comportant une chaîne de dispositif d'émission-réception radiofréquence telles que mentionnées dans les revendications.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 qui a été décrite précédemment est un schéma-bloc d'un système d'émission-réception radiofréquence du type auquel s'applique à titre d'exemple la présente invention ;
la figure 2 est une vue en coupe schématique d'un exemple de puce microélectronique adaptée à recevoir des éléments filaires ;
la figure 3 est une vue en coupe schématique d'un autre exemple de puce microélectronique adaptée à recevoir des éléments filaires ;
les figures 4A et 4B sont des vues de dessus d'un mode de réalisation, respectivement d'une chaîne de puces avant individualisation et d'un dispositif d'émission-réception radiofréquence obtenue à partir de cette chaîne ;
les figures 5A et 5B sont des vues de dessus d'un autre mode de réalisation d'une chaîne de dispositifs radiofréquence, respectivement avant et après formation des antennes ;
la figure 6 est une vue schématique de dessus d'une portion de plaquette de circuits intégrés ;
les figures 7A et 7B sont des vues de dessus d'un autre mode de réalisation de dispositifs radiofréquence, respectivement en chaîne et une fois individualisés, appliqué à des antennes en boucle ;
les figures 8A et 8B sont des vues de dessus schématiques illustrant, respectivement en chaîne et une fois individualisés, encore un autre mode de réalisation de dispositifs d'émission-réception radiofréquence ; et
les figures 9A et 9B sont des vues de dessus schématiques illustrant encore un autre mode de réalisation de chaîne de dispositifs d'émission-réception radiofréquence.

De mêmes éléments ont été désignés par de mêmes références aux différentes figures qui ont été tracées sans respect d'échelle.

### Description détaillée

Par souci de clarté, seuls les étapes et éléments utiles à la compréhension de l'invention ont été représentés et seront décrits. En particulier, les circuits électroniques internes aux dispositifs d'émission-réception radiofréquence n'ont pas été détaillés, l'invention étant compatible avec les circuits usuels (par exemple capteurs de mesure, identifiants d'un objet, etc.) en fonction de l'application visée. Les étapes de fabrication par lot des puces microélectroniques n'ont pas non plus été détaillées, l'invention étant là encore compatible avec les techniques usuelles.

L'invention sera décrite par la suite en relation avec un exemple de puces RFID, mais elle s'applique plus généralement à toute puce ou circuit d'émission-réception radiofréquence miniaturisé.

La figure 2 est une vue en coupe schématique d'une puce microélectronique 3 susceptible de constituer la puce d'une étiquette électronique du type de l'étiquette 2 de la figure 1. Un ou plusieurs circuits intégrés et composants sont portés par un substrat 33 dont au moins deux plots sont électriquement reliés (liaisons 31 et 32) à des zones de reprise de contact accessibles de l'extérieur de la puce 3 dans des zones d'accueil 35 destinées à des éléments de liaison filaires 41 et 42 (représentés en pointillés). Dans l'exemple de la figure 2, le substrat 33 est de part et d'autre enrobé d'un matériau isolant et protecteur 34, par exemple une résine époxy. Les zones d'accueil 35 sont ménagées de part et d'autre de la puce dans une première direction. La structure décrite en relation avec la figure 2 est un exemple du type de celle décrite dans le document WO-A-2008/025889.

Selon l'invention, les zones 36 sont destinées à reprendre des contacts de connexion d'antenne.

La figure 3 est une vue en coupe schématique d'un autre exemple de puce microélectronique 3. Par rapport à l'exemple de la figure 2, la face arrière du substrat 33 n'est pas recouverte de résine. Les zones d'accueil 35 des fils 41 et 42 sont constituées par des évidements parallèles réalisés dans la puce 3. Ces évidements peuvent, par exemple, être constitués par des rainures. De multiples formes de rainures sont possibles notamment à base carrée, en V, V tronqué ou en arc de cercle. Les dimensions ainsi que la forme des évidements seront, comme dans l'exemple précédent, choisies préférentiellement en fonction des caractéristiques des éléments de liaison filaire. A titre d'exemple, la profondeur et la largeur d'une rainure peuvent varier dans une gamme allant de 20 à 100 µm pour un élément de liaison 41 ou 42 de 20 à 100 µm de diamètre. Les zones métallisées 36 sont prévues, par exemple au fond des évidements 35, et servent selon la présente invention à reprendre des contacts de connexion d'antenne, par exemple par des vias conducteurs 32 dans le matériau isolant 34. Le cas échéant, les évidements 35 sont réalisés directement dans le substrat 33, préférentiellement à côté des composants microélectroniques. Les évidements 35 peuvent être réalisés par toute technique adaptée, par exemple, par gravure sèche ou humide, par sciage, etc.

Les structures des figures 2 et 3 peuvent subir diverses variantes, par exemple telles que décrites dans le document susmentionné.

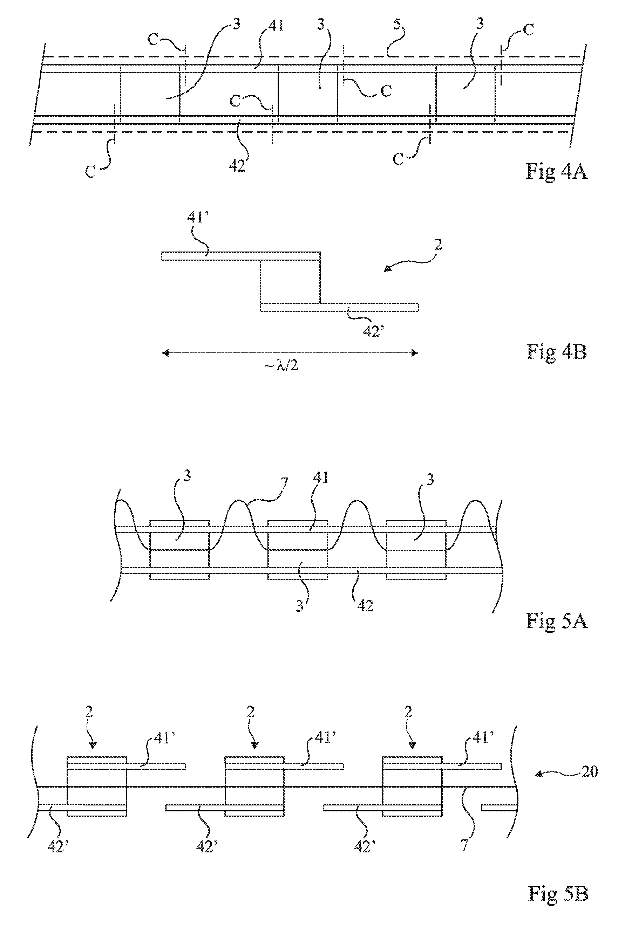

La figure 4A est une vue de dessus d'une chaîne de puces RFID 3 selon un mode de réalisation de la présente invention. La chaîne illustrée en figure 4A est par exemple obtenue, après découpe de puces 3 depuis une plaquette au moins partiellement en un matériau semiconducteur, en rapportant les puces sur une bande 5 les supportant temporairement à intervalles réguliers. Des fils conducteurs 41 et 42 sont ensuite disposés, de préférence latéralement par rapport aux puces 3, en étant en contact électrique avec les zones de reprise de contacts de chaque puce, accessibles depuis les logements 35 prévus pour les fils 41 et 42. Par exemple, les reprises de contact sont des métallisations réalisées, lors du traitement par lot en plaquette, à l'intérieur des logements latéraux. L'assemblage des fils 41 ou 42 par contact conducteur avec des zones conductrices 36 de la puce 3 est obtenu, par colle conductrice, par soudure, ou tout autre moyen adapté.

Enfin, les fils 41 et 42 sont sectionnés à intervalle régulier de la chaîne, par exemple à un bord de chaque puce 3 pour le fil 41 et à l'autre bord de chaque puce pour le fil 42 (le long des pointillés c illustrés en figure 4A), pour obtenir un dispositif RFID 2 équipé de son antenne.

La figure 4B est une vue schématique de dessus d'un dispositif RFID 2 obtenu après découpe des fils 41 et 42 de la figure 4A. L'antenne est dans cet exemple une antenne de type dipôle. Chaque puce 3 est associée à deux brins 41' et 42' issus des fils de liaison temporaire 41 et 42 pour former un dispositif 2.

La longueur des brins ou tronçons 41' et 42' qui subsistent une fois les puces individualisées est choisie pour être adaptée à la longueur voulue de l'antenne d'émission-réception radiofréquence. Dans l'exemple des antennes du type de celles illustrées en figure 4B, cette longueur est, par exemple, de l'ordre de λ/2 pour le cumul des deux brins 41' et 42' alignés, où λ représente la longueur d'onde de la fréquence centrale de la bande d'émission-réception.

Le diamètre des éléments filaires 41 et 42 est supérieur au diamètre d'éventuels fils de liaison (par exemple 32 et 33, figure 2) internes à la puce 3. Par exemple, ce diamètre est du même ordre de grandeur (rapport compris entre 1/4 et 1) que l'épaisseur de la puce 3 finie.

Tant que les fils 41 et 42 n'ont pas été découpés, ils assurent une fonction de maintien mécanique des puces 3 entre-elles permettant de maintenir celles-ci en chaîne, par exemple en rouleau, avant leur montage définitif sur l'objet qu'elles sont censées identifier.

Les figures 5A et 5B sont des vues de dessus illustrant un autre mode de réalisation, respectivement avant et après découpe des fils 41 et 42 pour individualiser les antennes. Selon cet exemple, les puces 3 restent reliées les unes aux autres au moyen d'un élément de liaison filaire 7. Ce fil 7 est fixé aux puces 3 avant découpe des fils 41 et 42, par exemple, alors que les puces sont encore en plaquettes ou portées par une bande temporaire du type de la bande 5 de la figure 3A. La longueur des tronçons de l'élément de liaison 7 entre chaque puce 3 est choisie pour être supérieure aux longueurs respectives des brins 41' et 42'. Cette longueur dépend de l'intervalle souhaité entre deux dispositifs radiofréquence dans l'application visée et est, par exemple, comprise entre quelques centimètres et quelques mètres. La présence de l'élément de liaison 7 permet de conserver les dispositifs RFID en chaîne 20 même après séparation des antennes, donc jusqu'à leur implantation finale sur l'objet.

Il peut d'agir, par exemple, de placer une chaîne 20 de puces RFID le long d'une canalisation enterrée afin d'en faciliter la localisation.

Selon un autre exemple, le fil de liaison 7 est incorporé à la place d'un fil de tissage pour répartir régulièrement des puces RFID dans un textile.

Le fil 7 est, par exemple, coupé à la demande en fonction de la longueur finale de chaîne souhaitée. Le fil 7 est de préférence isolant et sa résistance mécanique dépend de l'application visée. La section du fil 7 peut être circulaire ou autre (par exemple, rectangulaire), monobrin ou multibrin.

Le ou les éléments de liaison, qu'il s'agisse des éléments de liaison 41 et 42 destinés à former les brins d'antenne 41' et 42' ou d'éléments de liaison destinés à former un fil porteur 7 définitif, peuvent avoir une section ronde, carrée ou autre et être constitués par un fil ou un ensemble de fils. S'agissant des fils 41 et 42 destinés à former les antennes, ces éléments sont conducteurs (et le cas échéant gainés d'un isolant sauf aux contacts avec la puce).

Selon un exemple particulier de réalisation, les différentes puces sont réalisées sur une plaquette de substrat semi-conducteur ou isolant. Elles sont liées les unes aux autres par au moins un élément de liaison filaire (soit les fils 41 et 42 destinés à constituer les deux antennes, soit l'élément 7 de liaison pérenne, soit les deux). Puis, le substrat est ensuite structuré de façon à désolidariser les unes des autres les puces 3 qui sont alors reliées en série uniquement par la connexion mécanique souple au moyen du ou des éléments de liaison. La désolidarisation des puces 3 est réalisée dans le cas d'un substrat massif de manière classique, par exemple par sciage, en prenant soin de ne pas sectionner le ou les éléments de liaison.

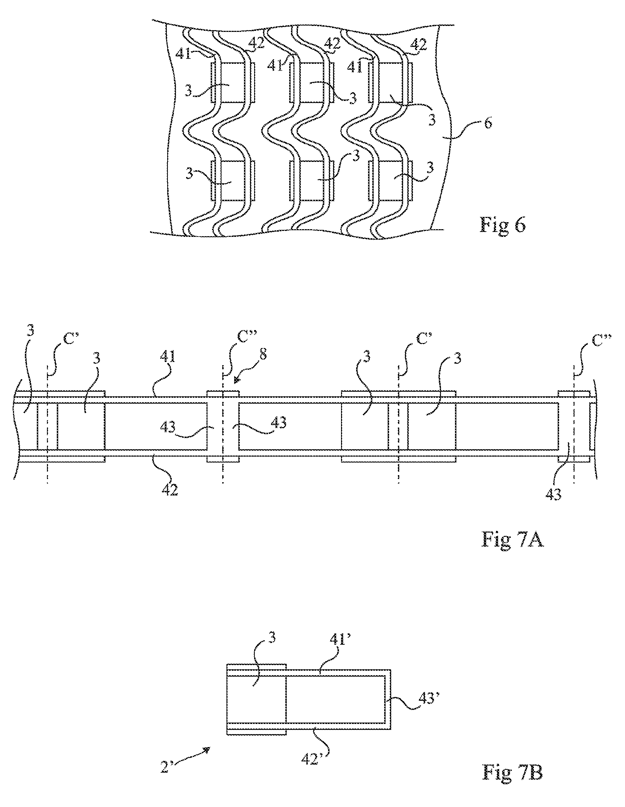

La figure 6 représente une portion 6 de plaquette substrat sur laquelle sont réalisées plusieurs puces RFID 3 selon ce mode de réalisation. Dans cet exemple, les éléments de liaison 41 et 42 sont associés aux puces 3 avant découpe. Cela peut éviter le recours à une bande support temporaire. Toutefois, selon la longueur d'antenne requise, cela peut demander un écart des puces entre elles relativement important par rapport à l'écart requis pour les chemins de découpe. De préférence, on prévoit alors, comme cela est représenté, une longueur de fils 41 et 42 entre deux puces qui soit supérieure à l'écart entre ces puces sur la plaquette, pour correspondre aux longueurs d'antenne souhaitées.

Si un support provisoire en bande 5 (figure 4A) sert à maintenir temporairement les puces 3 en chaîne, l'assemblage des fils 41 et 42 destinés à former les brins d'antenne peut intervenir postérieurement au placement des puces 3 sur la bande 5.

Les figures 7A et 7B sont des vues de dessus, respectivement avant et après découpe des fils d'antenne, d'un autre mode de réalisation plus particulièrement adapté à la formation d'antennes en boucle.

Selon cet exemple, dans la structure en chaîne des puces avant découpe des antennes (figure 7A), les fils de liaison 41 et 42 sont, entre deux puces, reliés l'un à l'autre par des éléments intermédiaires 8 comportant un tronçon conducteur 43 reliant les fils 41 et 42 l'un à l'autre. Par exemple, les puces 3 sont appariées deux à deux de sorte que des premiers traits de coupe (c') se situent entre deux puces sans laisser subsister de fil entre elles et que des seconds traits de coupe (c") se situent au niveau des éléments de liaison 8 de façon à laisser, de part et d'autre du trait de coupe c", un brin 43' reliant les brins 41' et 42' (figure 7B). La largeur des tronçons de liaison 43 dépend de la largeur du trait de coupe c" de façon à préserver, de part et d'autre, un tronçon conducteur 43'. En variante, deux tronçons 43' parallèles sont réalisés sur ou dans les éléments 8 de part et d'autre du trait de coupe c". Dans l'exemple des figures 7A et 7B, on prévoit que les dispositifs RFID 2' (figure 7B) sont finalement individualisés. Toutefois, une variante avec un élément de liaison permanent du type de celle illustrée en relation avec les figures 5A et 5B peut également être prévue.

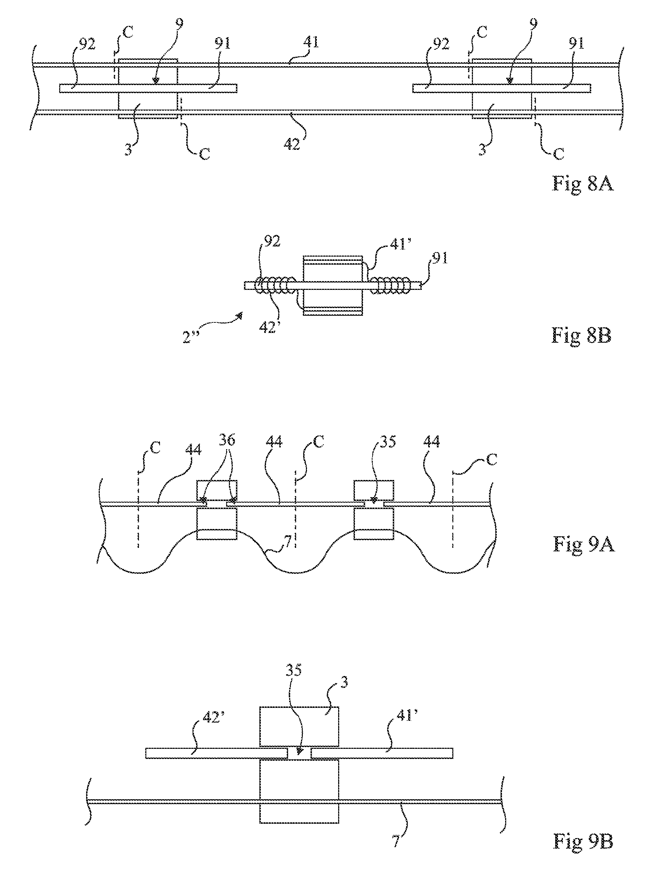

Les figures 8A et 8B sont des vues de dessus d'encore un autre mode de réalisation de puces RFID, respectivement en chaîne et individualisées.

Selon ce mode de réalisation, des éléments 9 de forme générale allongée et dépassant de part et d'autre de chaque puce 3 sont rapportés sur celles-ci après découpe depuis les plaquettes ou y sont intégrés en dépassant de part et d'autre de chaque puce 3 par des tronçons 91 et 92. Ces éléments 9 sont en un matériau isolant ou sont gainés d'un matériau isolant et sont destinés à recevoir les brins d'antenne respectifs 41' et 42' qui sont alors enroulés à la manière d'une bobine (figure 8B). Si les dispositifs RFID 2" obtenus sont destinés à rester en chaîne, les éléments 9 peuvent être des tronçons d'un fil porteur (7, figures 5A, 5B). Les éléments 9 sont indifféremment souples ou rigides et reçoivent les brins 41' et 42', par exemple, à la manière d'un "guipage" textile. En variante, les éléments 9 peuvent être en un matériau choisi pour ses propriétés électromagnétiques (par exemple, en ferrite).

Un avantage du mode de réalisation des figures 8A et 8B est que les caractéristiques des antennes sont améliorées, en particulier, en augmentant la partie imaginaire de leur impédance.

Les figures 9A et 9B illustrent, par des vues à rapprocher des figures précédentes, une variante selon laquelle chaque antenne est formée de deux brins 41' et 42' alignés de part et d'autre de chaque puce. Dans ce cas, la connexion en série des puces avant coupure des fils conducteurs est obtenue par un grand nombre de fils 44 (figure 8A) dont les longueurs respectives correspondent au double de la longueur souhaitée pour les brins d'antenne, et les zones 36 de reprise de contact avec les puces sont alignées. Le cas échéant, un fil porteur 7 est destiné à relier les dispositifs après coupure des fils conducteurs 44. La position des fils 44 est indifférente dans la largeur des puces 3 (par rapport à une direction longitudinale définie par la direction des fils 44).

Les différents modes de réalisation et variantes décrits ci-dessus sont bien entendu combinables.

Un avantage des modes de réalisation décrits est qu'ils permettent d'obtenir des dispositifs RFID dont les antennes sont réalisées par des éléments filaires moins onéreux que le dépôt d'encre conductrice sur un substrat isolant.

Un autre avantage est que la technique proposée préserve la possibilité de chaînes de puces radiofréquence au moins jusqu'au montage sur l'objet final (par section des brins d'antenne). Cela autorise des traitements des puces au déroulé, par exemple, des traitements galvaniques, d'enrobage, etc.

Un autre avantage est que les modes de réalisation décrits permettent même de préserver la structure en chaîne de puces radiofréquence dans l'application finale.

Divers modes de réalisation ont été décrits, diverses variantes et adaptations sont à la portée de l'homme du métier. En particulier, le choix des dimensions à donner aux brins d'antenne dépend de l'application et notamment de la fréquence de fonctionnement souhaitée ainsi que des autres composants (notamment les éléments capacitifs) présents côté puce électronique.

De plus, la réalisation pratique de l'invention est à la portée de l'homme du métier à partir des indications fonctionnelles données ci-dessus.

Enfin, bien que l'invention ait été décrite en relation avec un exemple de dispositifs pourvus chacun d'une antenne, on pourra prévoir deux antennes par dispositif pour autoriser un fonctionnement sur plusieurs bandes fréquences. Par exemple, dans une variante de la réalisation des dispositifs des figures 7A et 7B, un élément 8 peut être prévu entre chaque puce et les longueurs respectives des brins 41' et 42' sont différentes de part et d'autre d'une même puce, pour obtenir deux éléments inductifs de valeurs différentes. Le réglage de la bande de fréquences de fonctionnement en utilisant une seule antenne peut également être obtenue, de façon usuelle, par un réglage interne à la puce 3 en faisant varier l'élément capacitif C2 pour modifier la fréquence d'accord du circuit oscillant.

Un autre avantage est que les modes de réalisation décrits permettent même de préserver la structure en chaîne de puces radiofréquence dans l'application finale.

Divers modes de réalisation ont été décrits, diverses variantes et adaptations sont à la portée de l'homme du métier. En particulier, le choix des dimensions à donner aux brins d'antenne dépend de l'application et notamment de la fréquence de fonctionnement souhaitée ainsi que des autres composants (notamment les éléments capacitifs) présents côté puce électronique.

De plus, la réalisation pratique de l'invention est à la portée de l'homme du métier à partir des indications fonctionnelles données ci-dessus.

Enfin, bien que l'invention ait été décrite en relation avec un exemple de dispositifs pourvus chacun d'une antenne, on pourra prévoir deux antennes par dispositif pour autoriser un fonctionnement sur plusieurs bandes fréquences. Par exemple, dans une variante de la réalisation des dispositifs des figures 7A et 7B, un élément 8 peut être prévu entre chaque puce et les longueurs respectives des brins 41' et 42' sont différentes de part et d'autre d'une même puce, pour obtenir deux éléments inductifs de valeurs différentes. Le réglage de la bande de fréquences de fonctionnement en utilisant une seule antenne peut également être obtenue, de façon usuelle, par un réglage interne à la puce 3 en faisant varier l'élément capacitif C2 pour modifier la fréquence d'accord du circuit oscillant.

## Revendications

1. Procédé de fabrication de dispositifs (2, 2") d'émission-réception radiofréquence, **caractérisé en ce qu'**il comporte :
la réalisation de puces (3) d'émission-réception radiofréquence dépourvues d'antennes ;
la connexion en série des puces, chaque puce étant reliée à une puce voisine par au moins deux éléments filaires conducteurs, (41, 42) connectés à plus de deux puces, placés de part et d'autre des puces au voisinage de leurs bords latéraux respectifs dans une première direction, et dont les longueurs respectives sont choisies en fonction de la fréquence d'émission-réception ; chaque élément filaire conducteur contactant électriquement au moins une borne d'une puce (3) et assurant une fonction au moins temporaire de maintien mécanique des puces en chaîne ; et
la coupure de la connexion en série pour former, pour chaque puce, les brins (41', 42') d'une antenne du dispositif.

2. Procédé de fabrication de dispositifs (2') d'émission-réception radiofréquence, **caractérisé en ce qu'**il comporte :
la réalisation de puces (3) d'émission-réception radiofréquence dépourvues d'antennes ;
la connexion en série des puces, chaque puce étant reliée à un élément intermédiaire (8) entre deux puces par au moins deux éléments filaires conducteurs (41, 42), connectés à plus de deux puces, placés de part et d'autre des puces au voisinage de leurs bords latéraux respectifs dans une première direction, et dont les longueurs respectives sont choisies en fonction de la fréquence d'émission-réception ; chaque élément filaire conducteur contactant électriquement au moins une borne d'une puce (3) et assurant une fonction au moins temporaire de maintien mécanique des puces en chaîne ; chaque élément intermédiaire (8) portant au moins un tronçon conducteur (43) reliant les deux éléments filaires conducteurs (41, 42) et étant destiné à être coupé pour former, pour chaque puce, une antenne boucle ; et
la coupure de la connexion en série pour former, pour chaque puce, les brins (41', 42') d'une antenne du dispositif.

3. Procédé selon la revendication 1 ou 2, dans lequel, après coupure, deux brins de l'antenne d'une puce s'étendent respectivement d'un côté ou de l'autre de cette puce.

4. Procédé selon l'une quelconque des revendications 1 à 3, dans lequel les puces (3) sont rapportées sur une bande support (5) avant connexion par les éléments filaires conducteurs (41, 42, 44).

5. Procédé selon l'une quelconque des revendications 1 à 4, dans lequel un élément de liaison filaire (7) est, avant coupure de la connexion en série, relié aux différentes puces pour former, après coupure de la connexion en série, une chaîne de dispositifs radiofréquence.

6. Procédé selon la revendication 5, dans lequel les brins (41', 42') formés par la coupure des éléments conducteurs sont enroulés autour de l'élément de liaison (7).

7. Procédé selon l'une quelconque des revendications 1 à 6, dans lequel la liaison des éléments filaires conducteurs (41, 42, 44) à chaque puce (3) s'effectue au niveau de zones d'accueil reliées à des zones de reprise de contact de la puce.

8. Procédé selon l'une quelconque des revendications 1 à 7, dans lequel la coupure de la connexion en série est effectuée à intervalles réguliers.

9. Dispositif (2, 2', 2") d'émission-réception radiofréquence, **caractérisé en ce qu'**il comporte :
une puce microélectronique (3) intégrant des circuits d'émission-réception radiofréquence ; et
au moins deux brins (41', 42') d'antenne filaire obtenus par application du procédé conforme à l'une quelconque des revendications 1 à 8.

10. Chaîne de dispositifs (2, 2', 2") d'émission-réception de radiofréquence, comportant plusieurs puces électroniques (3) intégrant des circuits d'émission-réception radiofréquence et reliées les unes aux autres, chaque puce étant reliée à la puce voisine ou à un élément intermédiaire (8) entre deux puces par au moins deux éléments filaires conducteurs (41, 42, 44) connectés à des plots (36) de connexion d'antenne des puces, les longueurs respectives des éléments entre deux puces voisines ou entre une puce et un élément intermédiaire étant choisies en fonction de la fréquence d'émission-réception, chaque élément conducteur étant connectés à plus de deux puces et les éléments conducteurs étant placés de part et d'autre des puces au voisinage de leurs bords latéraux respectifs dans une première direction.

11. Chaîne (20) de dispositifs selon la revendication 10, dans laquelle un élément de liaison additionnel (7), de longueur supérieure aux longueurs respectives des éléments conducteurs (41', 42') entre deux puces voisines, relie les puces.

12. Canalisation comportant une chaîne de dispositifs selon l'une quelconque des revendications 10 à 11.

## Patentansprüche

1. Ein Verfahren zum Herstellen von Funkfrequenztransceivereinrichtungen (2, 2"), **dadurch gekennzeichnet, dass** das Verfahren folgendes aufweist:
Bilden von Funkfrequenztransceiverchips (3), die keine Antennen haben;
Reihenverbinden der Chips, wobei jeder Chip mit einem Nachbarchip durch mindestens zwei leitfähige Kabelelemente (41, 42) verbunden ist, die mit mehr als zwei Chips verbunden sind, die auf beiden Seiten der Chips in der Nähe ihrer jeweiligen Seitenkanten in einer ersten Richtung platziert sind, und die jeweilige Längen haben, die gemäß der Sende/Empfangsfrequenz ausgewählt sind; wobei jedes leitfähige Kabelelement elektrisch mindestens einen Anschluss eines Chips (3) kontaktiert und zumindest zeitweise die Chips mechanisch verbindet; und
Trennen der Reihenverbindung in regelmäßigen Intervallen, um für jeden Chip zwei Stränge (41', 42') einer Antenne der Einrichtung zu bilden.

2. Ein Verfahren zum Herstellen von Funkfrequenztransceivereinrichtungen (2'), **dadurch gekennzeichnet, dass** das Verfahren folgendes aufweist:
Bilden von Funkfrequenztransceiverchips (3), die keine Antennen haben;
Reihenverbinden der Chips, wobei jeder Chip durch mindestens zwei leitfähige Kabelelemente (41, 42) mit einem Zwischenelement (8) zwischen zwei Chips verbunden ist, wobei die Kabelelemente (41, 42) mit mehr als zwei Chips verbunden sind, die auf beiden Seiten der Chips in der Nähe ihrer jeweiligen Seitenkanten in einer ersten Richtung platziert sind, und die jeweiligen Längen haben, die gemäß der Sende/Empfangsfrequenz ausgewählt sind; wobei jedes leitfähige Kabelelement elektrisch mindestens einen Anschluss eines Chips (3) kontaktiert und zumindest zeitweise die Chips mechanisch verbunden lässt; wobei jedes Zwischenelement (8) mindestens eine leitfähigen Abschnitt (43) besitzt, der die zwei leitfähigen Kabelelemente (41, 42) verbindet und zum Trennen vorgesehen ist, um für jeden Chip eine Schleifenantenne zu bilden; und
Trennen der Reihenverbindung in regelmäßigen Intervallen, um für jeden Chip zwei Stränge (41', 42') einer Antenne der Einrichtung zu bilden.

3. Verfahren nach Anspruch 1 oder 2, wobei sich nach dem Trennen zwei Stränge der Antenne eines Chips von einer Seite bzw. von einer anderen Seite dieses Chips erstrecken.

4. Verfahren nach einem der Ansprüche 1 bis 3, wobei die Chips (3) auf einem Unterstützungsstreifen (5) platziert sind, und zwar bevor sie durch die leitfähigen Kabelelemente (41, 42, 44) verbunden werden.

5. Verfahren nach einem der Ansprüche 1 bis 4, wobei ein Kabelverbin-dungselement (7) vor dem Trennen der Reihenverbindung an einen unterschiedlichen Chip verbunden ist, um nach dem Trennen der Reihenverbindung eine Kette von Funkfrequenzeinrichtungen zu bilden.

6. Verfahren nach Anspruch 5, wobei die Stränge (41', 42'), die durch das Trennen der leitfähigen Elemente gebildet werden, um das Verbindungselement (7) herum gewickelt werden.

7. Verfahren nach einem der Ansprüche 1 bis 6, wobei die Verbindung zwischen den leitfähigen Kabelelementen (41, 42, 44) and jedem Chip (3) für jeden der Empfangsbereiche, die mit Kontaktbereichen des Chips verbunden sind, gemacht wird.

8. Verfahren nach einem der Anspruch 1 bis 7, wobei das Trennen der Rei-henverbindung in gleichmäßigen Abständen gemacht wird.

9. Eine Funkfrequenztransceivereinrichtung (2, 2', 2"), die **dadurch gekennzeichnet ist, dass** sie folgendes aufweist:
einen Microelektronikchip (3) der Funkfrequenztransceiverschaltkreise integriert; und
mindestens zwei Drahtantennenstränge (41', 42'), die durch Anwenden des Verfahrens nach einem der Ansprüche 1 bis 8 erhalten wurden.

10. Eine Kette von Funkfrequenztransceiverschaltkreisen (2, 2', 2"), die mehrere Elektronikchips (3) aufweisen, die Funkfrequenztransceiverschaltkreise integrieren und miteinander verbunden sind, wobei jeder Chip mit einem Nachbarchip oder mit einem Zwischenelement (8) zwischen zwei Chips durch mindestens zwei leitfähige Kabelelemente (41,42,44) verbunden ist, die mit Antennenverbindungs-pads (36) der Chips verbunden sind, wobei die jeweiligen Längen der Elemente zwischen zwei Nachbarchips oder zwischen einem Chip und einem Zwischenelement gemäß der Sende-Empfangsfrequenz ausgewählt ist, wobei jedes leitfähige Element mit mehr als zwei Chips verbunden ist und die leitfähigen Elemente auf beiden Seiten des Chips in der Nähe ihrer jeweiligen Seitenkanten in einer ersten Richtung verbunden ist.

11. Kette (20) von Einrichtungen nach Anspruch 10, wobei ein zusätzliches Verbindungselement (7), das eine Länge größer als die jeweiligen Längen der leitfähigen Elemente (41', 42') zwischen zwei Nachbarchips aufweist, die die Chips verbinden.

12. Ein Rohr, das die Kette von Einrichtungen nach Anspruch 10 oder 11 aufweist.

## Claims

1. A method for manufacturing radio frequency transceiver devices (2, 2"), **characterized in that** it comprises:
the forming of radio frequency transceiver chips (3) having no antennas;
the series connection of the chips, each chip being connected to a neighboring chip by at least two conductive cable elements (41, 42), connected to more than two chips, placed on either side of the chips in the vicinity of their respective lateral edges in a first direction, and the respective lengths of which are selected according to the transmission-reception frequency; each conductive cable element electrically contacting at least one terminal of a chip (3) and at least temporarily mechanically maintaining the chips chained; and
the cutting at regular intervals of the series connection to form, for each chip, two strands (41', 42') of an antenna of the device.

2. A method for manufacturing radio frequency transceiver devices (2'), **characterized in that** it comprises:
the forming of radio frequency transceiver chips (3) having no antennas;
the series connection of the chips, each chip being connected to an intermediary element (8) between two chips by at least two conductive cable elements (41, 42), connected to more than two chips, placed on either side of the chips, in the vicinity of their respective lateral edges in a first direction and the respective lengths of which are selected according to the transmission-reception frequency; each conductive cable element electrically contacting at least one terminal of a chip (3) and at least temporarily mechanically maintaining the chips chained; each intermediary element (8) supporting at least one conductive section (43) connecting the two conductive cable elements (41, 42) and being intended to be cut to form, for each chip, a loop antenna; and
the cutting at regular intervals of the series connection to form, for each chip, two strands (41', 42') of an antenna of the device.

3. The method of claim 1 or 2, wherein after cutting, two strands of the antenna of a chip respectively extend from one side or from the other side of this chip.

4. The method of any of claims 1 to 3, wherein the chips (3) are placed on a support strip (5) before connection by the conductive cable elements (41, 42, 44).

5. The method of any of claims 1 to 4, wherein a cable connection element (7) is, before cutting of the series connection, connected to the different chips to form, after cutting of the series connection, a chain of radio frequency devices.

6. The method of claim 5, wherein the strands (41', 42') formed by the cutting of the conductive elements are wound around the connection element (7).

7. The method of any of claims 1 to 6, wherein the link between the conductive cable elements (41, 42, 44) and each chip (3) is made of each receiving areas connected to contact areas of the chip.

8. The method of any of claims 1 to 7, wherein the cutting of the series connection is made at regular intervals.

9. A radio frequency transceiver device (2, 2', 2"), **characterized in that** it comprises:
a microelectronic chip (3) integrating radio frequency transceiver circuits; and
at least two wire antenna strands (41', 42') obtained by application of the method of any of claims 1 to 8.

10. A chain of radio frequency transceiver devices (2, 2', 2"), comprising several electronic chips (3) integrating radio frequency transceiver circuits and connected to one another, each chip being connected to a neighboring chip or to an intermediate element (8) between two chips by at least two conductive cable elements (41, 42, 44) connected to antenna connection pads (36) of the chips, the respective lengths of the elements between two neighboring chips or between a chip and an intermediate element being selected according to the transmission-reception frequency, each conductive element being connected to more than two chips and the conductive elements being placed on either side of the chip in the vicinity of their respective lateral edges in a first direction.

11. The chain (20) of devices of claim 10, wherein an additional connection element (7), having a length greater than the respective lengths of the conductive elements (41', 42') between two neighboring chips, connects the chips.

12. Pipe comprising a chain of devices of claim 10 or 11.
